# EUROPÄISCHE PATENTSCHRIFT

(11) **EP 1 431 768 B1**
(45) Veröffentlichungstag und Bekanntmachung des Hinweises auf die Patenterteilung: **31.08.2011**
(21) Anmeldenummer: 03027162.1
(22) Anmeldetag: 27.11.2003
(51) Int. Cl.: G01R 27/02

(54) **Verfahren und Vorrichtung zur Widerstandsmessung eines temperaturabhängigen Widerstandselements**
Method and Device for Resistance Measurement of a Temperature Dependent Resistor
Procédé et dispositif de mesure de la résistivité d'un élément de résistance sensible à la température

(30) Priorität: 12.12.2002 DE 10258366
(43) Veröffentlichungstag der Anmeldung: 23.06.2004
(73) Patentinhaber: ENDRESS + HAUSER WETZER GmbH + Co. KG, 87484 Nesselwang (DE); Endress + Hauser (Deutschland) Holding GmbH, 79576 Weil am Rhein (DE)
(72) Erfinder: Konrad, Stephan, 87669 Rieden (DE)
(74) Vertreter: Andres, Angelika Maria

(56) Entgegenhaltungen:
- EP-A- 0 521 234
- US-A- 3 735 254
- US-A- 6 045 260
- TAYLOR H R ET AL: "THE DYNAMIC THERMOMETER: AN INSTRUMENT FOR FAST MEASUREMENTS WITH PLATINUM RESISTANCE THERMOMETERS" TRANSACTIONS OF THE INSTITUTE OF MEASUREMENT AND CONTROL, INSTITUTE OF MEASUREMENT AND CONTROL. DORKING, GB, Bd. 15, Nr. 1, 1993, Seiten 11-18, XP000345830 ISSN: 0142-3312

## Beschreibung

Die Erfindung betrifft eine Vorrichtung zur Widerstandsmessung eines temperaturabhängigen Widerstandselements.

In der Prozesstechnik werden Temperaturen häufig über temperaturäbhängige Widerstandselemente ermittelt, ein Standardelement hierfür ist das PT100 Widerstandselement.

Zur Bestimmung des Widerstands sind unterschiedliche Techniken mit unterschiedlicher Genauigkeit bekannt. Die genaueste Variante ist die Vierleitermesstechnik, bei der Strom- und Messpfad völlig getrennt sind. Eine einfachere Variante ist die Dreileitermesstechnik, bei der eingangs- bzw. ausgangsseitig des Widerstandselements Strom- und Messpfad zusammengelegt sind. Die einfachste Ausgestaltung ist die Zweileitermessung, bei der sowohl eingangsseitig als auch ausgangsseitig Strom- und Messpfad zusammenfallen. Ein wesentlicher Nachteil bei den bekannten Temperaturmessgeräten, die nach einer dieser genannten Techniken arbeiten, ist, dass bei einem Leitungsbruch ein Messwert nicht mehr ermittelt werden kann und dadurch bei Einsatz eines derartigen Temperaturmessgerätes in größeren Anlagen, der Prozessablauf gegebenenfalls unterbrochen werden muss.

Aus der EP0521234A2 ist ein System zur Widerstandsmessung bekannt geworden, das so ausgestaltet ist, dass es einen Leitungsbruch in einer der beiden Messleitungen eines Vierdraht-Widerstands messgeräts er kennen kann. Sobald ein Leitungsbruch eletektiert wird, wird der Fehler angezeigt, so dass der defekte Widerstandssensor ausgetauscht werden kann.

Aufgabe der vorliegenden Erfindung ist es deshalb, eine Vorrichtung zur Widerstandsmessung eines temperaturabhängigen Widerstandselements anzugeben, das die oben genannten Nachteile nicht aufweist, das insbesondere eine Temperaturmessung bei einem Leitungsbruch noch ermöglicht.

Gelöst wird diese Aufgabe durch die in Anspruch 1 angegebene Vorrichtung.

Die wesentliche Idee der Erfindung besteht darin, bei einem Leitungsbruch den unterbrochenen Pfad auf eine intakte Anschlussleitung umzuschalten, um so eine Temperaturmessung mit geringerer Genauigkeit durchzuführen zu können.

Nachfolgend ist die Erfindung anhand eines in der Zeichnung dargestellten Ausführungsbeispiels näher erläutert.

Es zeigen:
- Fig. 1: eine bekannte Schaltungsanordnung zur Bestimmung des Widerstandes eines Widerstandselements in Vierleitertechnik;
- Fig. 2: eine Schaltungsanordnung zur Bestimmung des Widerstandes eines Widerstandselements in Dreileitertechnik;
- Fig. 3: eine Schaltungsanordnung zur Bestimmung des Widerstandes eines Widerstandselements in Zweileitertechnik;
- Fig. 4: eine erfindungsgemäße Schaltungsanordnung zur Bestimmung des Widerstandes eines Widerstandselements in Vierleitertechnik;

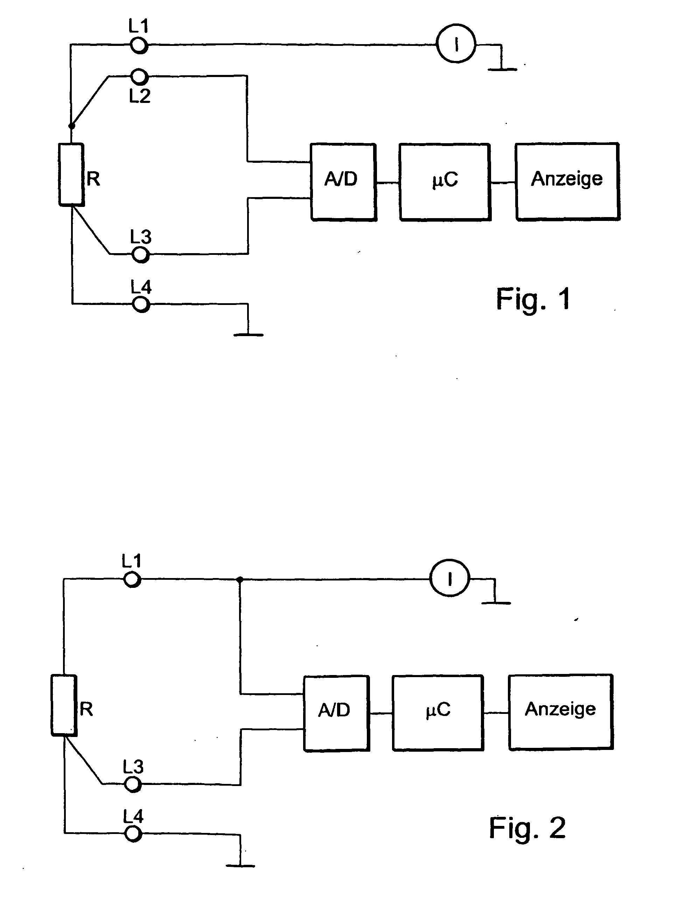

Fig. 1 zeigt eine Schaltungsanordnung zur Bestimmung des Widerstands eines Widerstandselements in Vierleitertechnik. Ein Widerstandselement R, dessen Widerstand temperaturabhängig ist, weist eingangsseitig zwei Anschlussleitungen L1, L2 und ausgangsseitig ebenfalls zwei Anschlussleitungen L3, L4 auf. Die Anschlussleitung L1 ist mit einem Stromgenerator I verbunden, der einen konstanten Strom liefert. Die beiden Anschlussleitungen L2 und L3 sind mit einem Analog-Digital-Wandler A/D verbunden, dem ein Mikro-Controller µC nachgeschaltet ist. Im Mikro-Controller µC werden die gemessenen Spannungswerte des Widerstandes R ausgewertet und ein Temperaturwert bestimmt. Zur optischen Anzeige des Messwertes dient eine Anzeigeeinheit A die ebenfalls mit dem Mikro-Controller µC verbunden ist. Bei der Vierleitertechnik sind Strompfad und Messpfad vollständig getrennt. Im vorliegenden Fall bilden die Leitungspaare L1 und L4 den Strompfad und die Leitungspaare L2 und L3 den Messpfad. Im Mikro-Controller µC erfolgt auch eine Linearisierung des Messsignals, das dann in der Anzeigeeinheit A dargestellt werden kann. Ein wesentlicher Vorteil der Vierleitertechnik ist, dass Widerstände in Leitungen und Steckverbindungen keine Messfehler verursachen.

In Fig. 2 ist eine Schaltungsanordnung zur Bestimmung des Widerstands eines Widerstandselements in Dreileitertechnik dargestellt. Im Unterschied zur Fig. 1 sind hier eingangsseitig des Widerstandselements R Strompfad und Messpfad in einer Anschlussleitung zusammengefasst. Im dargestellten Fall dient die Anschlussleitung L1 als gemeinsamer Strom- und Messpfad. Ansonsten ist die Schaltungsanordnung identisch zu der in der Fig. 1 dargestellten.

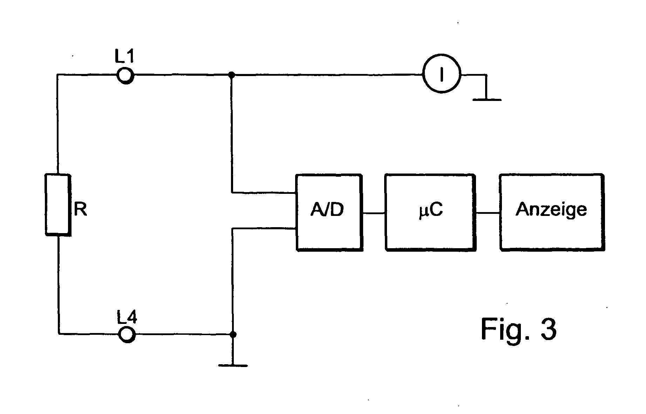

In Fig. 3 ist eine Schaltungsanordnung zur Bestimmung des Widerstands eines Widerstandselements in Zweileitertechnik dargestellt. In diesem Fall sind sowohl eingangsseitig als auch ausgangsseitig von dem Widerstandselement R Strom- und Messpfad identisch. Es werden deshalb nur zwei Anschlussleitungen L1 und L4 benötigt. Die Signalverarbeitung im Analog-Digital-Wandler A/D und Mikro-Controller µC entspricht derjenigen von Fig. 1 und Fig. 2.

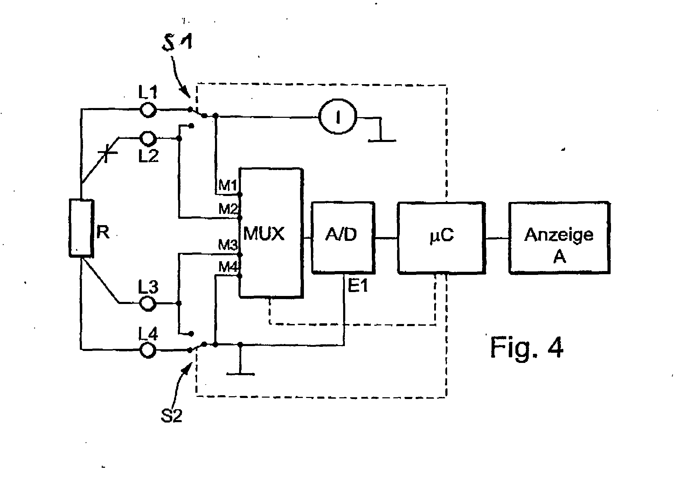

Fig. 4 zeigt eine erfindungsgemäße Schaltungsanordnung zur Bestimmung des Widerstands eines Widerstandselements. Bei dieser Schaltungsanordnung ist gegenüber der in Fig. 1 dargestellten Schaltungsanordnung in der Anschlussleitung L1 ein Schalter S1 vorgesehen, der den Stromgenerator I wahlweise mit der Anschlussleitung L1 bzw. L2 verbindet. Angesteuert wird der Schalter S1 vom Mikro-Controller µC. So kann bei einem Leitungsbruch in der Anschlussleitung L1 der Strompfad auf die Anschlussleitung L2 gelegt werden.

Weiterhin ist ausgangsseitig von dem Widerstandselement R in der Anschlussleitung L4 ein weiterer Schalter S2 vorgesehen, der wahlweise die Anschlussleitung L3 bzw. L4 mit Erde und dem Eingang E1 des Analog-Digital-Wandlers A/D verbindet.
Bei einem Leitungsbruch in der Anschlussleitung L4 wird der Strompfad über die Anschlussleitung L3 geschlossen.
Weiterhin ist eine Multiplexeinheit MUX dem Analog-Digital-Wandler A/D vorgeschaltet, deren erster Eingang M1 mit dem Stromgenerator, deren zweiter Eingang M2 mit der Anschlussleitung L2, deren dritter Eingang M3 mit der Anschlussleitung L3 und deren vierter Eingang M4 mit dem Eingang E1 des Analog-Digital-Wandlers A/D verbunden ist. Die Multiplexeinheit MUX wird vom Mikro-Controller µC angesteuert. Dadurch können die Anschlussleitungen L1, L2, L3 oder L4, die mit dem Analog-Digital-Wandler A/D verbunden werden sollen, ausgewählt werden.
Zur Übertragung des Messwertes an eine übergeordnete Steuereinheit kann der Mikro-Controller µC mit einem Feldbus (Profibus®, Foundation® Fieldbus, CAN-Bus etc.) oder einem Zweidrahtanschluss (4-20mA, HART®) verbunden sein.

Nachfolgend ist die Funktionsweise der erfindungsgemäßen Schaltungsanordnung näher erläutert. Im Normalbetrieb arbeitet die Schaltungsanordnung in Vierleitertechnik. Die beiden Schalter S1 und S2 sind in der dargestellten Stellung. Als Strompfad dienen die Anschlussleitung L1 und L4 und als Messpfad dienen die beiden Anschlussleitungen L2 und L3. Der Analog-Digital-Wandler A/D ist über die Multiplexeinheit MUX abwechselnd mit der Anschlussleitung L2 bzw. der Anschlussleitung L3 verbunden. Im Mikro-Controller µC kann so der Spannungsabfall über dem Widerstandselement R bestimmt werden und in der Anzeigeeinheit A der entsprechende Temperaturwert zur Anzeige gebracht werden.

Wird ein Leitungsbruch in einer der Anschlussleitungen L1 und L2, L3 oder L4 festgestellt, so schaltet der Mikro-Controller µC die entsprechenden Pfade, Strom- bzw. Messpfad, um.

Im dargestellten Fall, wenn ein Leitungsbruch an der mit x gekennzeichneten Stelle in der Anschlussleitung L2 erfolgt, ist das Potential am Eingang M2 nicht definiert, Der Analog-Digital-Wandler gibt ein entsprechendes Signal ab.
Der Mikro-Controller µC schaltet daraufhin die Multiplexeinheit MUX so, dass nun abwechselnd der Eingang M1 bzw. M3 mit dem Analog-Digital-Wandler A/D verbunden ist. Eingangsseitig wird dadurch der Mess- und Strompfad auf die Anschlussleitung L1 verlegt. Dadurch erfolgt die Messung nur noch in Dreileitertechnik. Das Messergebnis ist zwar nicht so genau wie bei einer Vierleitermessung, aber wichtig ist, dass zumindest ein Messwert bestimmt werden kann. Eventuell kann der Leitungsbruch innerhalb kurzer Zeit von einem entsprechenden Service-Techniker repariert werden. Bis zu diesem Zeitpunkt wird ein Messwert geliefert, der eine geringere Genauigkeit aufweist, mit dem aber der Betrieb der Anlage weiterhin aufrecht erhalten werden kann. Über eine Statusmeldung kann das Messgerät den Fehler an eine Steuereinheit weiterleiten.

Ist sowohl eingangsseitig in einer der Anschlussleitungen L1, L2 wie auch ausgangsseitig in einer der Anschlussleitungen L3, L4 ein Leitungsbruch vorhanden, so schaltet der Mikro-Controller µC sowohl Strom- als auch Messpfad auf das unbeschädigte Leitungspaar um. Festgestellt wird ein derartiger Leitungsbruch ebenfalls wieder vom Mikro-Controller µC über die vom Analog-Digital-Wandler ermittelte Spannungsdifferenz, die in einem solchen Fehlerfall auf Null fällt.
Tritt ein doppelter Leitungsbruch auf, so kann ein Messwert nur bestimmt werden, wenn einer der Leitungsbrüche eingangsseitig des Widerstandselements R und einer ausgangsseitig passiert. Tritt ein Leitungsbruch in der Anschlussleitung L1 und L2 auf, so nützt auch eine Umschaltung auf Zweileitertechnik nichts mehr, da der Strompfad unterbrochen ist. Ein Messwert kann nicht erzeugt werden und eine entsprechende Meldung wird an die Steuereinheit übermittelt.

Mit der erfindungsgemäßen Vorrichtung ist es auch bei einem Leitungsbruch noch möglich einen Messwert zu erfassen. Dieser Messwert ist zwar etwas ungenauer aber in den meisten Fällen für eine Übergangszeit ausreichend bis eine Behebung des Leitungsbruchs erfolgt kann.

## Patentansprüche

1. Vorrichtung zur Widerstandsmessung eines temperaturabhängigen Widerstandselements (R) in Vierleitertechnik, bestehend aus
einem ersten Paar von Anschlussleitungen (L1, L4) für das Widerstandselement (R), die mit einem Stromgenerator (I) einen Strompfad bilden, und
einem zweiten Paar von Anschlussleitungen (L2, L3) für das Widerstandselement (R), die mit einem Analog/Digital-Wandler (A/D) verbunden sind und einen Messpfad bilden,
einer dem Analog/Digital-Wandler (A/D) vorgeschalteten Multiplexeinheit (MUX), deren Eingänge jeweils mit einer der Anschlussleitungen (L1, L2, L3, L4) des ersten und zweiten Paares von Anschlussleitungen (L1, L4; L2, L3) verbunden sind,
einem ersten Schalter (S1), der im Strompfad eingangsseitig von dem Widerstandselement (R) vorgesehen ist,
einem zweiten Schalter (S2), der im Strompfad ausgangsseitig von dem Widerstandselement (R) vorgesehen ist,
wobei der erste Schalter (S1) einen mit dem Stromgenerator (I) verbundenen
Mittelanschluss aufweist und den Stromgenerator (I) wahlweise mit einer ersten Anschlussleitung (L1) des ersten Paares von Anschlussleitungen (L1, L4) bzw. einer ersten Anschlussleitung (L2) des zweiten Paares von Anschlussleitungen (L2, L3) verbindet,
wobei der zweite Schalter (S2) einen mit Erde verbundenen Mittelanschluss aufweist und wahlweise eine zweite Anschlussleitung (L4) des ersten Paares von Anschlussleitungen (L1, L4) bzw. eine zweite Anschlussleitung (L3) des zweiten Paares von Anschlussleitungen (L2, L3) mit Erde verbindet, und
einem Mikrocontroller (µC), der die Multiplexeinheit (MUX) und den ersten und den zweiten Schalter (S1, S2) so ansteuert, dass im Fall eines Leitungsbruchs eingangsseitig von dem Widerstandselement (R) entweder in der ersten Anschlussleitung (L1) des ersten Paares von Anschlussleitungen (L1, L4) oder in der ersten Anschlussleitung (L2) des zweiten Paares von Anschlussleitungen (L2, L3) und/oder ausgangsseitig von dem Widerstandselement (R) entweder in der zweiten Anschlussleitung (L4) des ersten Paares von Anschlussleitungen (L1, L4) oder in der zweiten Anschlussleitung (L3) des zweiten Paares von Anschlussleitungen (L2, L3) eine Messung des Widerstandswerts des Widerstandselements (R) in Dreileitertechnik bzw.
in Zweileitertechnik erfolgt.

2. Vorrichtung nach Anspruch 1,
wobei der Mittelanschluss des ersten Schalters (S1) mit dem Eingang (M1) der Multiplexeinheit (MUX) verbunden ist, der im Normalbetrieb mit der ersten Anschlussleitung (L1) des ersten Paares von Anschlussleitungen (L1, L4) verbunden ist, und
wobei der Mittelanschluss des zweiten Schalters (S2) mit dem
Eingang (M4) der Multiplexeinheit (MUX) verbunden ist, der im Normalbetrieb mit der zweiten Anschlussleitung (L4) des ersten Paares von Anschlussleitungen (L1, L4) verbunden ist.

3. Vorrichtung nach einem der vorhergehenden Ansprüche,
wobei der Mikrocontroller (MUX) zur Darstellung des Widerstandswertes mit einer Anzeigeeinheit (A) verbunden ist.

## Claims

1. Unit designed for measuring the resistance of a temperature-dependent resistor element (R) with four-wire technology, comprising:
a first pair of connection wires (L1, L4) for the resistor element (R), which form a current path with a current generator (I), and a second pair of connection wires (L2, L3) for the resistor element (R), which are connected to an analog/digital converter (A/D) and form a measuring path
a multiplex unit (MUX) which is located upstream from the analog/digital converter (A/D). Each input of the MUX is connected to one of the connection wires (L1, L2, L3, L4) of the first and second pair of the connection wires (L1, L4; L2, L3) a first switch (S1) which is provided in the current path, at the input side of the resistor element (R)
a second switch (S2) which is provided in the current path, at the output side of the resistor element (R)
where the first switch (S1) has a common point connected to the current generator (I) and connects the current generator (I) to either the first connection wire (L1) of the first pair of connection wires (L1, L4), or to a first connection wire (L2) of the second pair of connection wires (L2, L3),
where the second switch (S2) has a grounded common point and connects either a second connection wire (L4) of the first pair of connection wires (L1, L4) or a second connection wire (L3) of the second pair of connection wires (L2, L3) to ground, and a microcontroller (µC) that controls the multiplex unit (MUX) and the first and second switch (S1, S2) in such a way that the resistance value of the resistor element (R) is measured using three-wire or two-wire technology if a wire breaks on the input side of the resistor element (R) either in the first connection wire (L1) of the first pair of connection wires (L1, L4) or in the first connection wire (L2) of the second pair of connection wires (L2, L3) and/or on the output side of the resistor element (R) either in the second connection wire (L4) of the first pair of connection wires (L1, L4) or in the second connection wire (L3) of the second pair of connection wires (L2, L3).

2. Unit as per Claim 1,
where the common point of the first switch (S1) is connected to the input (M1) of the multiplex unit (MUX) which is connected, during normal operation, to the first connection wire (L1) of the first pair of connection wires (L1, L4) and
where the common point of the second switch (S2) is connected to the input (M4) of the multiplex unit (MUX) which is connected, during normal operation, to the second connection wire (L4) of the first pair of connection wires (L1, L4).

3. Unit as per one of the previous claims, where the microcontroller (MUX) is connected to a display unit (A) to display the resistance value.

## Revendications

1. Dispositif destiné à la mesure de résistance d'un élément de résistance (R) variable avec la température, en technique quadrifilaire, constitué
d'une premier paire de lignes de raccordement (L1, L4) pour l'élément de résistance (R) qui, avec un générateur de courant (I), constituent un circuit de courant, et une deuxième paire de lignes de raccordement (L2, L3) pour l'élément de résistance (R), qui sont reliées avec un convertisseur analogique/numérique (A/N) et constituent un circuit de mesure,
d'une unité de multiplexage (MUX) couplée en amont du convertisseur analogique/numérique (A/N), dont les entrées sont respectivement reliées avec l'une des lignes de raccordement (L1, L2, L3, L4) de la première et de la deuxième paire de raccordement (L1, L2, L3, L4),
d'un première commutateur (S1), qui est prévu dans le circuit de courant, côté entrée de l'élément de résistance (R),
d'un deuxième commutateur (S2), qui est prévu dans le circuit de courant, côté sortie de l'élément de résistance (R),
le premier commutateur (S1) présentant un point commun relié avec le générateur de courant (I), et reliant au choix le générateur de courant (I) avec une première ligne de raccordement (L1) de la première paire de lignes de raccordement (L1, L4) ou une première ligne de raccordement (L2) de la deuxième paire de raccordement (L2, L3),
le deuxième commutateur (S2) présentant un point commun relié avec la terre, et reliant au choix la terre avec une deuxième ligne de raccordement (L4) de la première paire de lignes de raccordement (L1, L4) ou une deuxième ligne de raccordement (L3) de la deuxième paire de raccordement (L2, L3), et
d'un microcontrôleur (µC), qui pilote l'unité de multiplexage (MUX) et le premier et le deuxième commutateur (S1, S2), de telle manière qu'en cas de rupture de fil côté entrée de l'élément de résistance (R), une mesure de la valeur de résistance de l'élément de résistance (R) est réalisée en technique trifitaire ou en technique bifilaire, soit dans la première ligne de raccordement (L1) de la première paire de lignes de raccordement (L1, L4) ou soit dans la première ligne de raccordement (L2) de la deuxième paire de lignes de raccordement (L2, L3) et/ou, côté sortie de l'élément de résistance (R), soit dans la deuxième ligne de raccordement (L4) de la première paire de lignes de raccordement (L1, L4) ou soit dans la deuxième ligne de raccordement (L3) de la deuxième paire de lignes de raccordement (L2, L3).

2. Dispositif selon la revendication 1,
pour lequel le point commun du premier commutateur (S1) est relié avec l'entrée (M1) de l'unité de multiplexage (MUX) qui, en fonctionnement normal, est reliée avec la première ligne de raccordement (L1) de la première paire de lignes de raccordement (L1, L4),
et
pour lequel le point commun du deuxième commutateur (S2) est relié avec l'entrée (M4) de l'unité de multiplexage (MUX) qui, en fonctionnement normal, est reliée avec la deuxième ligne de raccordement (L4) de la première paire de lignes de raccordement (L1, L4).

3. Dispositif selon l'une des revendications précédentes,
pour lequel le microcontrôleur (MUX) est relié avec une unité d'affichage (A) pour la représentation de la valeur de résistance.
